(19) Europäisches Patentamt
European Patent Office
Office européen des brevets

(11) **EP 4 621 851 A1**

(12) **EUROPEAN PATENT APPLICATION**
published in accordance with Art. 153(4) EPC

(43) Date of publication:
**24.09.2025 Bulletin 2025/39**

(21) Application number: **23906302.7**

(22) Date of filing: **18.01.2023**

(51) International Patent Classification (IPC):
**H01L 29/06** (2006.01)     **H01L 29/78** (2006.01)
**H01L 29/872** (2006.01)

(52) Cooperative Patent Classification (CPC):
**H10D 8/60; H10D 30/60; H10D 62/10**

(86) International application number:
**PCT/JP2023/001274**

(87) International publication number:
**WO 2024/134916 (27.06.2024 Gazette 2024/26)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **19.12.2022 JP 2022201771**

(71) Applicant: **Shindengen Electric Manufacturing
Co., Ltd.
Tokyo 100-0004 (JP)**

(72) Inventors:
• **HASHIMOTO, Masaki
Asaka-shi Saitama 351-0015 (JP)**
• **SUEMOTO, Ryuji
Asaka-shi Saitama 351-0015 (JP)**

(74) Representative: **Pes, Matteo
Biesse S.r.l.
Patent Department (sesto piano)
Via Corfù, 71
25124 Brescia (BS) (IT)**

(54) **SEMICONDUCTOR DEVICE**

(57)    [Object] To provide a semiconductor device for ensuring a high voltage tolerance while enhancing an adhesion performance of an insulation layer.

[Means for Solving Problem] A semiconductor device 1 of the present invention is a semiconductor device 1 which has a substrate 10, an epitaxial layer 20 formed to the substrate 10, and insulation layers 40, 50 disposed at the one-face 20a side of epitaxial layer 20, wherein an active layer 60 is disposed to the one-face 20a side of epitaxial layer with intervening the insulation layer 40, and a trench 71 is disposed to a peripheral region 70 formed at an outside region of the active layer 60, and wherein an insulation layer 50 disposed to the peripheral region 70 is configured by layering a first insulator 51 and a second insulator 52.

**Fig. 1**

## Description

### Technical Field

The present invention relates to a semiconductor device.

### Background Art

In a semiconductor device, an insulation layer is disposed to insulate between an epitaxial layer formed on a substrate and an element constructing an active region. For this insulation layer, for example, an oxide film such as silicon oxides etc. has been used as disclosed in Patent Literature 1.

### Prior Art Literature

Patent Literature

Patent Literature 1 JP2020-505769

### Summary of Invention

### Problem to be Solved by Invention

Now, a semiconductor device includes a guard-ring structure, which is formed by an ion-implantation and a diffusion process of P-type semiconductor, as the structure of peripheral region for determining the voltage tolerance of elements such as a trench-schottky barrier diode. However, the guard-ring structure was difficult to ensure the voltage tolerance, and hence a void region around the peripheral region tended to become large. In addition, there were also problems that the formation of guard-ring required many processes, and costs became expensive. Thus, conventionally trench structures were sometimes used in place of the guard-ring structure. That is, by using the trench structure, the voltage tolerance can be ensured; the void region of peripheral region can be reduced; and production costs can also be reduced.

In recent years, enhancing the voltage tolerance is further required; however, conventionally an oxide film such as silicon oxides (for example, $SiO_2$) etc. has been used usually such that the concentration of electric field sometimes occurred, and there were the cases in which the high voltage-tolerance was difficult to be ensured even when the trench structures were used. In addition, in the case in which only the silicon oxides (for example, $SiO_2$) etc. are used as the insulation layer, adhesion performance becomes poor to resins for package materials such that external moisture penetrated between the package-material resin and the insulation layer, thereby resulting in the degradation of performance in semiconductor devices such as fluctuations in charges inside the insulation layer.

The present invention has been completed by considering the above situations and aims to provide a semiconductor device for ensuring high-voltage tolerance while improving the adhesion performance to the insulation layer.

### Means for Solving Problem

For solving the above problem, a semiconductor device of the present invention is a semiconductor device having a substrate, an epitaxial layer formed to the substrate, and an insulation layer disposed at the one-face side of epitaxial layer, wherein an active layer is disposed to a one-face side of the epitaxial layer with intervening the insulating layer, and a trench is disposed to a peripheral region formed at an outside region of the active layer, and wherein an insulation layer disposed to the peripheral region is configured by layering to a first insulator and a second insulator having different relative dielectric constants.

According to the present invention, the trench is disposed to the peripheral region where the region outside the active region and the insulation payer disposed to the peripheral region is configured by layering the first insulator and the second insulator having different relative dielectric constants, thereby even if the concentration of electric field occurs in any of the first insulator and the second insulator having relatively lower relative dielectric constant, the concentration of electric field can be mitigated by the other one of any of the first insulator and the second insulator having relatively higher relative dielectric constant. Thereby, the high voltage tolerance can be ensured synergistically together with the effect of trench. Furthermore, by disposing and layering the first insulator and the second insulator, thereby the adhesion performance of insulation layer (for example, adhesion performance between a resin for packaging material and the insulation layer) can be further enhanced and the penetration of outside moisture can be prevented.

The relative dielectric constant of second insulator is set to be 5-200, thereby the concentration of electric field can be further mitigated. The relative dielectric constant of second insulator is set to be 5-30, and further to be 5-10, thereby the concentration of electric field can be further mitigated. The insulation layer further includes a protection film, and the protection film is disposed by layering the first insulator and the second insulator, thereby the adhesion performance of insulation layer (for example, adhesion performance between a resin for packaging material and the insulation layer) can be further enhanced.

The first insulator includes oxides, thereby an insulation effect can be enhanced.

The oxides may include silicon oxides. The second insulator may include silicone compounds or oxides, thereby components become common and the adhesion performance of insulation layer (for example, adhesion performance between a resin for packaging material and the insulation layer) can be further enhanced.

The silicon compound may include silicon nitrides. The oxides may at least include any of hafnium oxides, titanium oxides and aluminum oxides.

The protection film may include polyimides or polyimide compounds, thereby the adhesion performance of insulation layer (for example, adhesion performance between a resin for packaging material and the insulation layer) can be further enhanced.

A channel-current suppression region is disposed to a terminal end region of the peripheral region, and a trench is further disposed to the channel-current suppressing region, thereby a channel current can be suppressed, and further high voltage tolerance can be synergistically ensured together with a configuration with the layered first insulator and second insulator.

The channel-current suppressing region is further disposed with an electrode for suppressing the channel-electrode, thereby the channel current flowing the terminal end region can be further suppressed synergistically together with the effect of trench.

An electrode for suppressing the channel current may be an EQR electrode, thereby voltages can be kept in an equal voltage, and the channel current flowing in a terminal end region can be suppressed.

The trench disposed to the channel-current suppressing region is disposed by notching stepwise a terminal end region side in the one-face side of epitaxial layer, and a trench having the stepwise shape is configured to open an outer lateral side, thereby resistance becomes large and the channel current flowing in the terminal end can be further suppressed.

The trench having the stepwise shape can be further disposed with a trench at the bottom, thereby the channel-current flowing in the terminal end region can be further suppressed synergistically together with the stepwise shape and the trench at the bottom.

### Advantageous Effect

According to the present invention, high-voltage tolerance can be ensured, and the adhesion performance of insulation layer can be improved.

### Brief Description of Drawings

Fig. 1 is a plane view illustrating a semiconductor device according to a first embodiment of the present invention.

Fig. 2 is an AA front cross-sectional view of Fig. 1 illustrating the configuration of the same semiconductor device.

Fig. 3 is an enlarged front cross-sectional view illustrating the structure of trench in the same semiconductor device.

Fig. 4 is a front cross-sectional view illustrating a semiconductor device according to a second embodiment of the present invention.

Fig. 5 is a front cross-sectional view illustrating a modified example of the same semiconductor device.

Fig. 6 is another front cross-sectional view illustrating a modified example of the same semiconductor device.

Fig. 7 is further another front cross-sectional view illustrating a modified example of the same semiconductor device.

Fig. 8 is a plane view illustrating a configuration of semiconductor device according to a third embodiment of the present invention.

Fig. 9 is an AA front cross-sectional view of Fig. 8 illustrating the configuration of the same semiconductor device.

Fig. 10 is an enlarged front cross-sectional view illustrating the configuration of trench at a terminal end region of the same semiconductor device.

Fig. 11 is a plane view illustrating a configuration of semiconductor device according to a fourth embodiment of the present invention.

Fig. 12 is a front cross-sectional view illustrating a modified example of the same semiconductor device.

Fig. 13 is another front cross-sectional view illustrating a modified example of the same semiconductor device.

Fig. 14 is further the other front cross-sectional view illustrating a modified example of the same semiconductor device.

Fig. 15 is yet further the other front cross-sectional view illustrating a modified example of the same semiconductor device.

Fig. 16 is the other front cross-sectional view illustrating a modified example of the same semiconductor device.

Fig. 17 is further the other front cross-sectional view illustrating a modified example of the same semiconductor device.

Fig. 18 is yet further the other front cross-sectional view illustrating a modified example of the same semiconductor device.

Fig. 19 is yet further the other front cross-sectional view illustrating a modified example of the same semiconductor device.

## Embodiment for Practicing Invention

[First Embodiment]

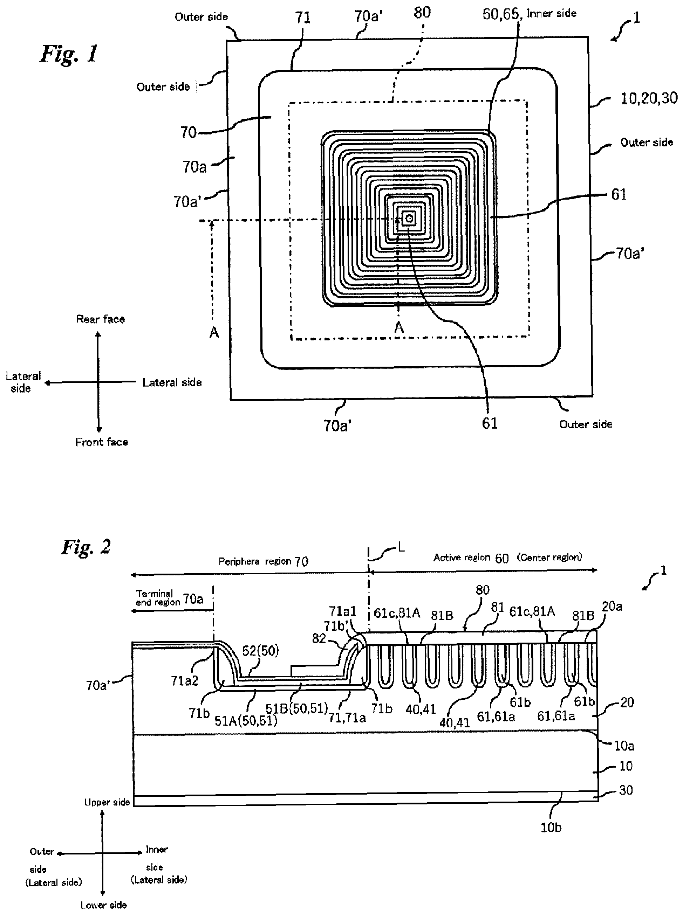

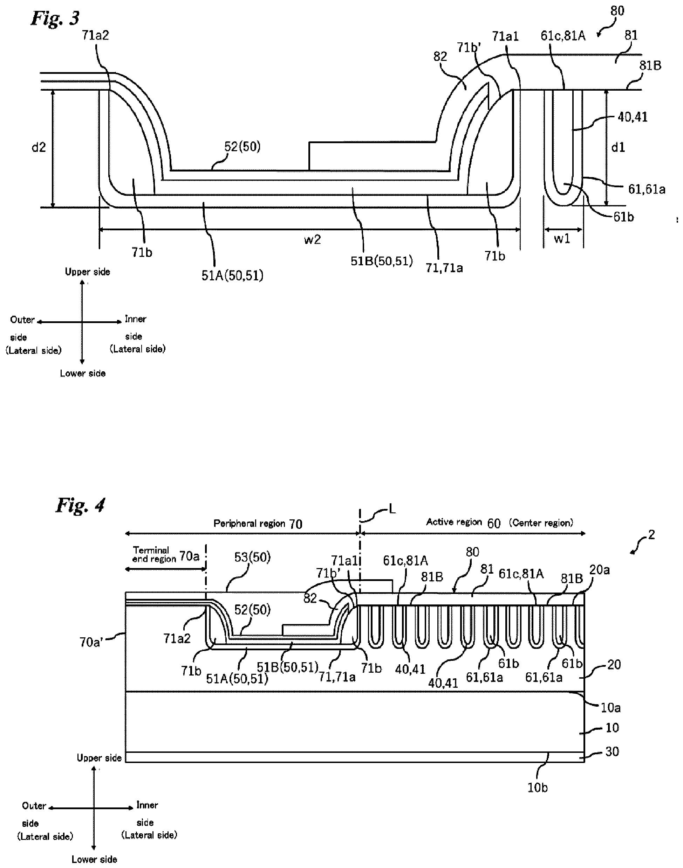

A semiconductor device 1 according to a first embodiment of the present invention will be described with reference to Figs. 1-3. Fig. 1 is a plane view illustrating a semiconductor device according to a first embodiment of the present invention; Fig. 2 is an AA front cross-sectional view of Fig. 1 illustrating the configuration of the same semiconductor device; and Fig. 3 is an enlarged front cross-sectional view illustrating the structure of trench in the same semiconductor device. Here, in the descriptions hereunder, in the positioning which is viewed from the substrate 10 of semiconductor device 1, an upper side is defined to the side of epitaxial layer 20; a lower side is defined to the side of cathode electrode etc. 30; the center region 65 side of semiconductor device 1 is defined to an inner side; the terminal region 70a side (the side of terminal end 70a') is defined to an outer side; and each of the sides including other sides will be indicated clearly in drawings.

With reference to Fig. 1-Fig. 3, the outline of semiconductor device 1 according to the first embodiment of the present invention will be described. The semiconductor device 1 has a rectangular shape (square shape) in its plane view and comprises a substrate 10, an epitaxial layer 20, a cathode electrode or a drain electrode 30 (for example, referred to the drain electrode in a MOSFET; while being referred to the cathode electrode in a diode; and hereafter referred to the cathode etc. 30), insulation layers 40, 50, an active region 60 and a peripheral region 70. The insulation layer 40 is disposed to the active region 60, and the insulation layer 50 is disposed to the peripheral region 70. The upper side of insulation layer 50, not shown in the drawing, is sealed by a packaging material resin.

The substrate 10 can be formed from a predetermined electric-conductive material having a platelike shape. The substrate 10 is the substrate made of single crystal, and the epitaxial layer 20 is formed at the upper side of one-face 10a which becomes the upper side of substrate 10. At the other face 10b, which becomes the lower side of substrate 10, the cathode electrode etc. 30 is disposed. The cathode electrode etc. 30 can be made of an electric-conductive material such as metals etc. Between the cathode electrodes etc. 30 and the active region 60, a predetermined voltage difference is generated to flow current through the active region 60 such that the active region 60 can be made functioned.

The epitaxial layer 20 can be formed by performing epitaxial growth to the entire face at the one-face 10a of substrate 10. To the one-face 20a side, which becomes the upper side of epitaxial layer 20, insulation layers 40, 50 are disposed in a predetermined manner. To the one-face 20a side of epitaxial layer 20, the active region 60 is disposed with intervening the insulation layer 40, and the peripheral region 70 is disposed at the outer region of active region 60. The insulation layer 50 is disposed to the peripheral region 70. That is, the active region 60 and the peripheral region 70 are insulated in a predetermined manner from the epitaxial layer 20 with intervening the insulation layers 40, 50.

The active region 60 is disposed to the region at the side of center region 65 (inner side) in which the main current flows. To the active region 60, the plural trenches 61 are disposed.

The trench 61 is disposed to form a recess at predetermined positions at the one-face 20a side of epitaxial layer 20. The trench 61 has a U-shape in its cross-sectional shape viewed from the front having a predetermined depth size (recess depth size) d1 and a width (trench width) size w1 and has a recessed shape disposed for going around the one-face 20a side of epitaxial layer 20. To the recessed inner face 61a of trench 61, the insulation layer 40 is disposed. That is, the trench 61 is insulated to the epitaxial layer 20. In a space surrounded by the inner face 61a of trench 61, an electric conductive material 61b is filled to an upper end with intervening the insulation layer 40. An opening 61c at the upper end of trench 61 is closed by the electric conductive material 61b. The electric conductive material 61b may be, various electric conductive materials, for example, such as polysilicon, impurity-doped silicon, metal (metals) etc.

The insulation layer 40 disposed to the trench 61 is formed by an insulator 41. The insulator 41 may include oxides, and the oxides may include the silicon oxides (for example, silicon dioxide ($SiO_2$)).

A trench 71 is disposed to the peripheral region 70. The trench 71 is disposed to form recesses at the predetermined positions at the one-face 20a side of epitaxial layer 20. The trench 71 has a rectangular-shape (laterally longer rectangle shape) in a cross-sectional shape viewed from the front having a predetermined depth size (recess depth size) d2 and a width (trench width) size w2 and has a recessed shape disposed for going around the one-face 20a side of epitaxial layer 20. The width size w2 of trench 71 at the peripheral region 70 has a larger size than the width size w1 of trench 61 at the active region 60. By disposing the trench 71 to the peripheral region 70, the voltage tolerance can be ensured while reducing the production costs.

At the recessed inner face 71a of trench 71 and the terminal end region 70a side of peripheral region 70, an insulation layer 50 is disposed (the terminal end region 70a of peripheral region 70 means the region at the outer side of trench 71.). That is, the peripheral region 70, more particularly the trench 71 and the terminal end region 70a side of peripheral region 70 are insulated to the epitaxial layer 20.

The insulation layer 50 disposed to the peripheral region 70 is configured by layering a first insulator 51 and a second insulator 52, which have different relative dielectric constants. The first insulator 51 further includes a lower insulator 51A and an upper insulator 51B. The lower insulator 51A is disposed directly to the one-face 20a side of epitaxial layer 20 at the inner face 71a of trench 71. The upper insulator 51B is disposed by being layered on the upper face of lower insulator 51A at the inner face 71a of trench 71. The upper insulator 51B is disposed directly at the one-face 20a side of epitaxial layer 20 from the outer end region 71a2 to the terminal end 70a' of trench 71.

The lower insulator 51A and the upper insulator 51B include the oxides, and the oxides may include the silicon oxides (for example, silicon dioxide ($SiO_2$)). The relative dielectric constants of silicon oxides, for example, such as silicon dioxide ($SiO_2$) range around 3-4. At both end regions 71a1, 71a2 of trench 71, an electric conductive material 71b intervenes between the lower insulator 51A and the upper insulator 51B. Precisely, at the end region 71a2 side of active region 60 side in the trench 71, the upper insulator 51B and the second insulator 52 do not reach the end region 71a2 (boundary L between the peripheral region 70 and active region 60); the electric conductive material 71b is exposed to the upper insulator 51B and the second insulator 52; and the exposed region 71b' of electric conductive material 71b contacts with a field-plate electrode 82 and a schottky electrode 81. The electric conductive material 71b may be various conductive materials, for example, such as polysilicon, impurity-doped silicon and metal (metals) etc.

The second insulator 52 is disposed by layering above the upper face of first insulator 51, more particularly, of upper insulator 51B. The second insulator 52 is disposed for covering entirely the upper face of first insulator 51. The second insulator 52 is set to have a larger relative dielectric constant than that of first insulator 51. The relative dielectric constant of second insulator 52 may be 5-200, more preferably may be 5-30, and further preferably may be 5-10. The second insulator 52 may preferably include silicon compounds and oxides, and the silicon compounds may preferably include silicon nitrides (for example, silicon nitride (SiN, $Si_3N_4$)). The oxides may preferably include at least any of hafnium oxides (for example, hafnium dioxide ($HfO_2$)), titanium oxides (for example, titanium dioxide $TiO_2$)), and aluminum oxides ($Al_2O_3$). By using the oxide film as the first insulator 51 such as silicon oxides (for example, silicon dioxide ($SiO_2$)) etc., the concentration of electric-field might occur; however, the concentration of electric-field may be mitigated by layering the second insulator 52.

The relative dielectric constant of second insulator 52 is to be about 7-8 for SiN and $Si_3N_4$; to be about 80-190 for $TiO_2$; to be about 7-10 for $Al_2O_3$; and to be about 10-20 for $HfO_2$, and SiN, $Si_3N_4$, $Al_2O_3$ and $HfO_2$ having the relative dielectric constants in the range of 5-30 contribute particularly to the enhancement of adhering performance. Furthermore, SiN and $Si_3N_4$ having the relative dielectric constants of about 5-10 have narrower spacings between molecules in the nitride film than those of $SiO_2$ oxide film such that the effect for suppressing the penetration of moisture becomes larger and contributes moreover to the enhancement of adhesion performance with the packaging-material resin. Particularly, the nitride film has the superior adhesion performance with the field-plate electrode 82, and by sandwiching the nitride film rather than by forming the film of field-plate electrode 82 on the oxide film, the peeling-off of field-plate electrode 82 can be prevented.

To the active region 60, the diode 80 is disposed. The diode 80 may be a schottky-barrier diode (SBD: Schottky Barrier Diode) 80. The schottky-barrier diode 80 has the schottky electrode 81 and the field-plate electrode 82. The schottky electrode 81 is disposed to the active region 60. The schottky electrode 81 is the electrode part that performs the primary function of the schottky barrier diode 80, and the main current flows through it.

The schottky-barrier electrode 81 has a first-electrode part 81A and a second-electrode part 81B. The first electrode part 81A and the second-electrode part 81B continue each other.

The first-electrode part 81A is the electrode part which is disposed so as to cover the opening 61c of trench 61. The first-electrode part 81A contacts directly with the electric-conductive material 61b filled in the trench 61 without intervening the insulation layer 40.

The second-electrode part 81B is the electrode part which contacts directly with the one-face 20a of epitaxial layer 20. That is, insulating layer 40 is not disposed around the opening 61c of trench 61 at the one-face 20a of epitaxial layer 20, and the second-electrode part 81B is formed as the part, which is disposed directly on the epitaxial layer 20 without intervening the insulation layer 40.

The field-plate electrode 82 is disposed for extending to the outer side of active layer 60. That is, the field-plate electrode 82 is disposed in the manner that it reaches the intermediate region of trench 71 at the peripheral region 70 outside the active layer 60. The field-plate electrode 82 is configured to be made longer and shorter depending on a designed voltage tolerance. The field-plate electrode 82 is disposed to cover the upper face of second insulator 52 on the inner face 71a of trench 71. The field-plate electrode 82 is the electrode part which provides the function for mitigating the strength of electric-field. The schottky electrode 81 and the field-plate electrode 82 are disposed and continued to form a stepwise shape.

As described above, according to the semiconductor device 1 of the first embodiment of the present invention, the trench 71 is disposed to the peripheral region 70 at the outside region of active region 60, and the insulation layer 50 disposed to the peripheral region 70 is configured by layering the first insulator 51 and the second insulator 52 having the different relative dielectric constants such that, in the case where the concentration of electric field in the first insulator 51 having relatively lower relative dielectric constant, the concentration of electric field can be mitigated by the second insulator 52 having relatively higher relative dielectric constant. Thereby, the higher-voltage tolerance can be ensured synergistically together with the effect of trench 71.

Besides, by layering and disposing the first insulator 51 and the second insulator 52, the adhesion performance between the packaging-material resin and the insulation layer 50 can be enhanced, and the penetration of moisture from the outside between the packaging-material resin and the insulation layer can be also prevented.

Furthermore, by setting the relative dielectric constant of second insulator 52 to be 5-200, preferably to be 5-30, and further preferably to be 5-10, the concentration of electric field can be further mitigated.

Moreover, since the first insulator 51 includes the oxides, the insulation effect can be enhanced.

Also moreover, since the second insulator 52 includes the silicon compounds or the oxides, components become common with the first insulator 51 such that the adhesion performance between the packaging-material resin and the insulator 50 can be further enhanced. Besides, since the second insulator 52 is disposed for entirely covering the upper face of first insulator 51, the penetration of moisture can be further suppressed. Furthermore, since at the end region 71a2 side of active region 60 side in the trench 71, the upper insulator 51B and the second insulator 52 do not reach the end region 71a2; the electric conductive material 71b is exposed to the upper insulator 51B and the second insulator 52; and the exposed region 71b' of electric conductive material 71b becomes the same voltage level due to the contact with the field-plate electrode 82 and the schottky electrode 81 such that the peripheral concentration of electric field can be mitigated. Here, in the case where the upper insulator 51B and the second insulator 52 do not reach the electric conductive material 71b, the distributions in the electric-field strength becomes different between the covered and the uncovered regions by the first insulator 51 and the second insulator 52 below the field-plate electrode 82, and this may cause the unstable voltage tolerance and lowered voltage tolerance.

[Second Embodiment]

A semiconductor device 2 according to the second embodiment of the present invention will be described in detail with reference to Fig. 4. Now, in the following descriptions and Fig. 4, with respect to configurations indicated by the signs same with the above-described embodiment and the similar configurations without descriptions, the descriptions would be sometimes omitted as they have the configurations similar with the above-described embodiments. Furthermore, in the descriptions hereunder, in the positioning which is viewed from the substrate 10 of semiconductor device 2, an upper side is defined to the side of epitaxial layer 20; a lower side is defined to the side of cathode electrode etc. 30; the center region 65 side of semiconductor device 2 is defined to an inner side; the terminal region 70a side (the side of terminal end 70a') is defined to an outer side; and each of the sides including other sides will be indicated clearly in drawings.

The semiconductor device 2 according to the second embodiment of the present invention has a configuration further including a protection film 53 as well as the insulation layer 50. The protection film 53 is disposed by layering the first insulator 51 and the second insulator 52. More particularly, the protection film 53 is layered on the upper face of second insulator 52 from the terminal end region 70a of the peripheral region 70 to the intermediate region of trench 71 and is disposed for covering the upper face of field-plate electrode 82 from the intermediate region of trench 71 to the terminal end side outside the active region 60. The protection film 53 may include polyimides or polyimide compounds.

As described above, the insulation layer 50 further includes the protection film 53, and the protection film 53 is disposed by layering on the first insulator 51 and the second insulator 52, thereby the adhesion performance between the packaging-material resin and the insulation layer 50 can be further improved.

Furthermore, since the protection film 53 includes the polyimides or the polyimide compounds, the adhesion performance between the packaging-material resin and the insulation layer 50 can be further improved.

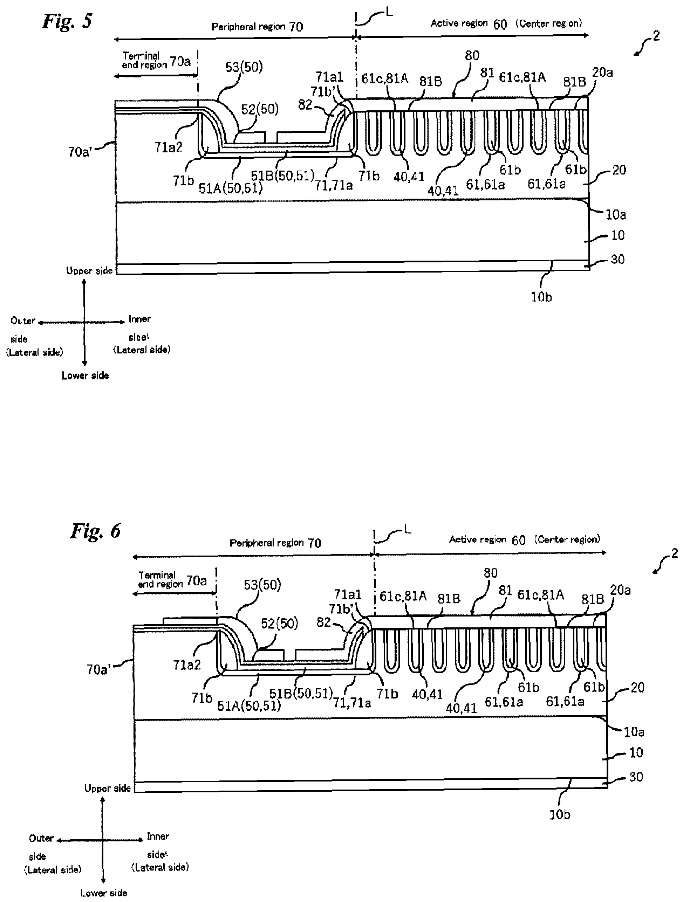

Here, as shown in Fig. 5, the protection film 53, even when assuming it to have the configuration not reaching the upper face of field-plate electrode 82 and when assuming it to be layered only on the upper face of second insulator 52 from the terminal end region 70a of peripheral region 70 and the intermediate region of trench 71, can obtain necessary effects.

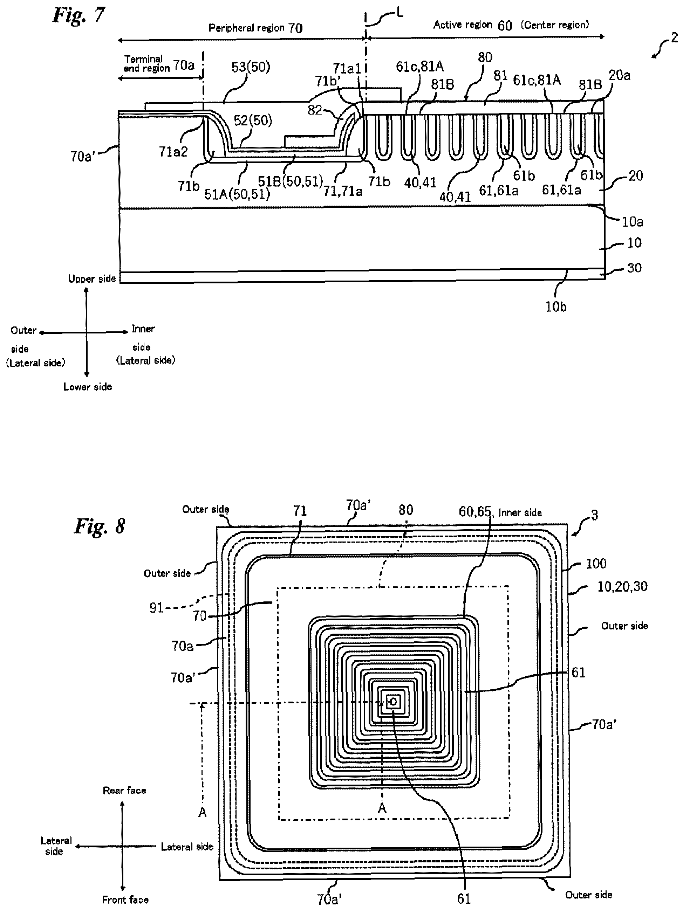

Furthermore, as shown in Fig. 6 and Fig. 7, the protection film 53, even when assuming it to be disposed not to reach the terminal end 70a' outside the terminal end region 70a of peripheral region 70, can provide necessary effects.

[Third Embodiment]

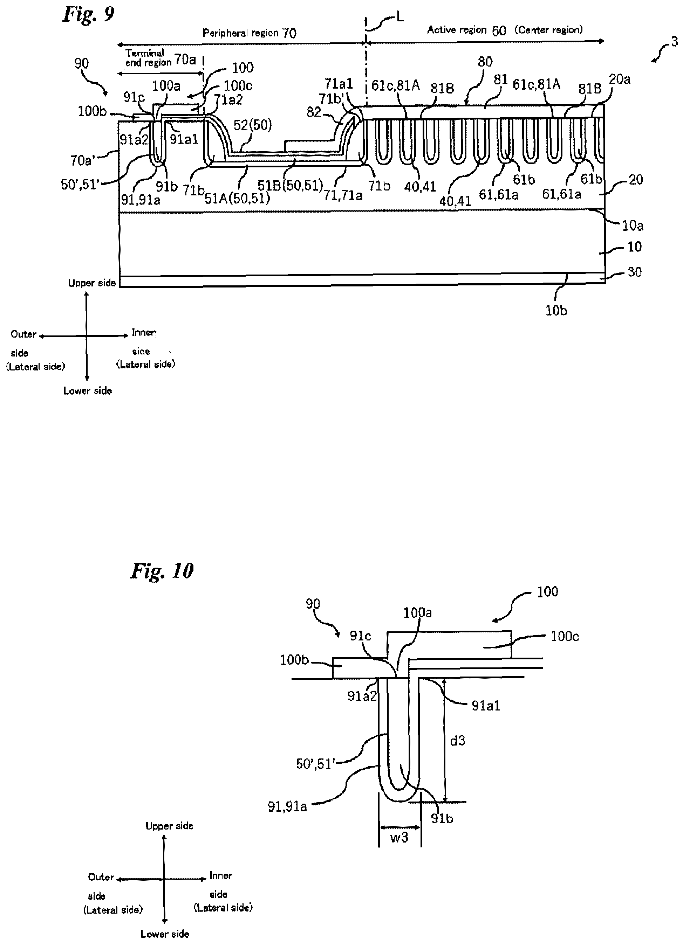

A semiconductor device 3 according to the third embodiment of the present invention will be described in detail with reference to Fig. 8-Fig. 10. Fig. 8 is a plane view illustrating a semiconductor device according to the third embodiment of the present invention; Fig. 9 is an AA front-cross sectional view of Fig. 8 which illustrates the configuration of the same semiconductor device; and Fig. 10 is an enlarged front-cross sectional view of trench structure at the terminal end region of the same semiconductor device. Now, in the following description and from Fig. 8-Fig. 10, with respect to configurations indicated by the signs same with the above-described embodiments and the similar configuration without descriptions, the descriptions would be sometimes omitted as they have the similar configurations with the above-described embodiment. In addition, in the descriptions hereunder, in the positioning which is viewed from the substrate 10 of semiconductor device 3, an upper side is defined to the side of epitaxial layer 20; a lower side is defined to the side of cathode electrode etc. 30; the center region 65 side of semiconductor device 3 is defined to an inner side; the terminal region 70a side (the side of terminal end 70a') is defined to an outer side; and each of the sides including other sides will be indicated clearly in drawings.

The semiconductor device 3 according to the third embodiment of the present invention has a configuration in which a channel-current suppressing region 90 is disposed to the terminal end region 70a side in the peripheral region 70. The channel-current suppressing region 90 is disposed for enclosing the trench 71 at the outside of trench 71 in the peripheral region 70. That is, a trench 91 is further disposed to the channel-current suppressing region 90, and the trench 91 can suppress the channel current flowing from the active region 60 to the terminal end region 70a. To the channel-current suppressing region 90, an electrode 100 for suppressing the channel current is disposed.

The trench 91 is disposed outside the trench 71. The trench 91 is disposed to make a recess in the predetermined position at the one-face 20a side of epitaxial layer 20. The trench 91 has a U-shape in a cross-sectional shape viewed from the front having a predetermined depth size (recess depth size) d3 and a width (trench width) size w3 and has a recessed shape disposed for going around the one-face 20a side of epitaxial layer 20.

The depth size d3 of trench 91 is set to the size to be the same with and/or to be larger than the depth size d1 of trench 61 disposed to the active region 60. Furthermore, the width size w3 of trench 91 (trench width) is set to the size to be the same with and/or to be larger than the depth size w3 of trench 61 (trench width) disposed to the active region 60.

To the recessed inner face 91a of trench 91, an insulation layer 50' is disposed. That is, the trench 91 is insulated to the epitaxial layer 20. In the space surrounded by the inner face 91a of trench 91, an electric conductive material 91b is filled to the upper end with intervening the insulation layer 50'. The opening 91c at the upper end of trench 91 is closed by the electric conductive material 91b. The electric conductive material 91b may be, various electric conductive materials, for example, such as polysilicon, impurity-doped silicon and metal (metals) etc.

The insulation layer 50' disposed to the trench 91 is configured only by the first insulator 51'. The first insulator 51' includes oxides, and the oxides may include silicon oxides (for example, silicon dioxide ($SiO_2$)).

That is, in the semiconductor device 3, the insulation layer 50 is continuous from the trench 71 starting from the end region 71a2 outside the trench 71 within the terminal end region 70a till the inner-end region 91a1 inside the trench 91 where both of the first insulator 51 and the second insulator 52 are layered. On the other hand, the insulation layer 50' disposed to the trench 91 is configured only by the first insulator 51' and has the configuration in which the second insulator 52 is not layered. Now, the insulation layer is not disposed from the outer-end region 91a2 outside the trench 91 to the terminal end 70a' of terminal end region 70a.

The electrode 100 for controlling the channel current is an EQR (Equipotential Ring: equipotential ring) electrode 100.

The EQR electrode 100 is disposed as a ring shape which goes around the one-face 20a side of epitaxial layer 20. The EQR electrode 100 can set a predetermined EQR region to the same potential. In the inside region of ring shape in the EQR electrode 100, the active regio 60 and the trench 71 are disposed.

The EQR electrode 100 may be formed by an electric conductive material. The EQR electrode 100 has a first-electrode part 100a, a second-electrode part 100b and a third-electrode part 100c. The first-electrode part 100a, second-electrode part 100b, and third-electrode part 100c are disposed continuously to form a stepwise shape.

The first-electrode part 100a is disposed so as to cover the opening 91c of trench 91. The first-electrode part 100a contacts directly with the electric conductive material 91b filled in the trench 91 without intervening the insulation layer.

The second-electrode part 100b is the electrode part which practically extends outward from the first-electrode part 100a as a short-striped shape.

The second-electrode part 100b contacts directly with the one-face 20a of epitaxial layer 20. That is, as described above, to the region starting from the end region 91b outside the trench 91 at the one-face 20a of epitaxial layer 20 till the terminal end 70a' of terminal end region 70a, the insulation layer is not disposed, and the second-electrode part 100b becomes the region which is disposed directly to the epitaxial layer 20 without intervening the insulation layer. The EQR electrode 100 contacts electrically with the epitaxial layer 20 with intervening the second-electrode part 100b disposed directly to the epitaxial layer 20.

The third-electrode part 100c practically extends toward a center region 65 side (inner side) from the first-electrode part 100a. The third-electrode part 100c is disposed to the epitaxial layer 20 with intervening the insulation layer 50.

In the semiconductor device 3 as configured above, when the diode 80 of active region 60, more particularly, the schottky-barrier diode 80 is functioned by supplying the main current, the channel is formed by charges due to such as passivation etc. toward the terminal end region 70a side (outside) from the schottky-barrier diode 80; however, by disposing the trench 91 in the channel-current suppression region 90, the flow of channel current toward the terminal end region 70a side (outside) from the active region 60 can be intercepted by the trench 91 in the channel-current suppressing region 90 such that the channel current flowing to the terminal end region 70a (outside) can be suppressed. Furthermore, the trench 91 is also disposed to the active region 60 similarly, and the trench 61 of active region 60 and the trench 91 of channel-current suppressing region 90 are disposed at the same time, and the like, and thus the channel current can be suppressed while forming the channel-current suppressing structure precisely without increasing production processes.

Furthermore, the channel-current suppressing region 90, which is further disposed with the electrode 100 for suppressing the channel current, may further suppress the channel current flowing in the terminal end region 70a side (outside) synergistically together with the effect of trench 91.

That is, by configuring the electrode 100 for suppressing the channel current as the EQR electrode 100, the cathode electrode etc. 30 and the channel-current suppressing region 90 can be kept at the same voltage such that the channel current flowing outside the terminal end region 70a (outside) can be suppressed.

Furthermore, since the EQR electrode 100 has the second-electrode part 100b which is directly disposed to the epitaxial layer 20 without intervening the insulation layer, the EQR electrode 100 and the epitaxial layer 20 are connected electrically. Thereby, the other face 20b side becoming the bottom side of epitaxial layer 20 and the EQR electrode 100 can be brought to the same voltage, and hence, the channel current flowing from the active region 60 to the terminal end region 70a side (outside).

Furthermore and moreover, by setting the depth size d3 of trench 91 disposed to the channel-current suppressing region 90 to the size same with and/or larger than the depth size d1 of trench 61 disposed to the active region 60 while by setting the width size w3 of trench 91 disposed to the channel-current suppressing region 90 to the size same with and/or larger than the width size w1 of trench 61 disposed to the active region 60, the channel current flow can be further intercepted by the trench 91 disposed to the channel-current suppressing region 90.

Also moreover, by adopting the diode 80 as the element disposed to the active region 60, the performance degradation caused by the inverse current of diode 80 from the above channel current can be suppressed.

By adopting the diode 80 as the schottky-barrier diode 80, since the schottky-barrier diode 80 has the large inverse current, the suppression effect against the performance degradation can be further enhanced.

[Fourth Embodiment]

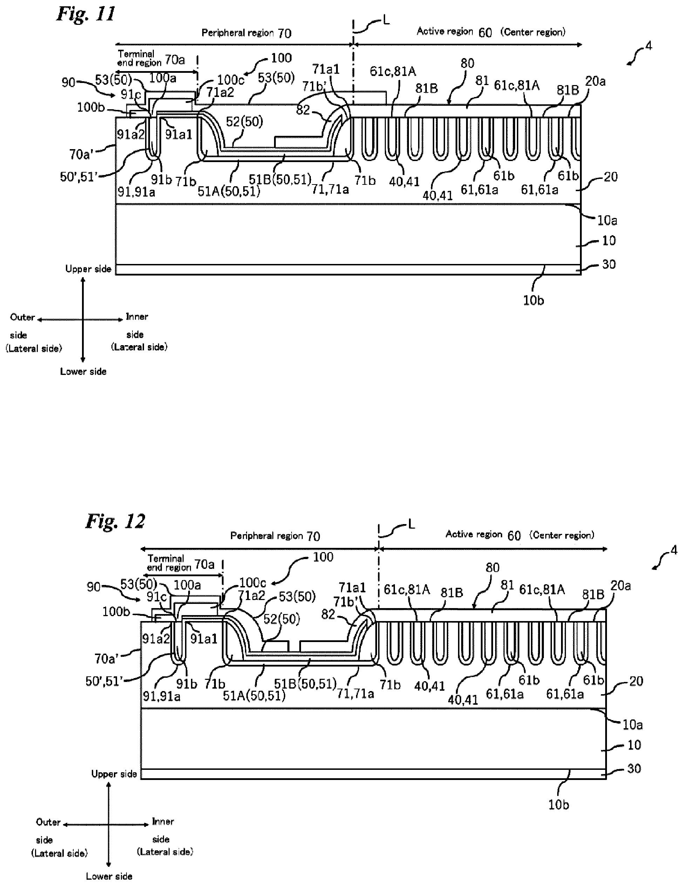

A semiconductor device 4 according to the fourth embodiment of the present invention will be described in detail with reference to Fig. 11. Now, in the following description and in Fig. 11, with respect to configurations indicated by the signs same with the above-described embodiment and the similar configuration without descriptions, the descriptions would be sometimes omitted as they have similar configurations with the above-described embodiments. In addition, in the descriptions hereunder, in the positioning which is viewed from the substrate 10 of semiconductor device 4, an upper side is defined to the side of epitaxial layer 20; a lower side is defined to the side of cathode electrode etc. 30; the center region 65 side of semiconductor device 4 is defined to an inner side; the terminal region 70a side (the side of terminal end 70a') is defined to an outer side; and each of the sides including other sides will be indicated clearly in drawings.

The semiconductor device 4 according to the fourth embodiment of the present invention has a configuration in which the protection film 53 is further included as well as the insulation layer 50. The protection film 53 is disposed with being layered to the first insulator 51 and the second insulator 52. In detail, the protection layer 53 is layered to the upper-face side of second insulator 52 from the end region 91a inside the trench 91 to the intermediate region of trench 71 (in the region where the EQR electrode 100 is placed, the upper-face side of EQR electrode 100 is layered to cover it.) and is disposed to cover the upper face of field-plate electrode 82 from the intermediate region of trench 71 to the end region side outside the active region 60. The protection film 53 may include the polyimides or the polyimide compounds.

In the fourth embodiment, the insulation layer 50 further includes the protection film 53, and since the protection film 53 is disposed by layering to the first insulator 51 and the second insulator 52, the adhesion performance between the packaging-material resin and the insulation layer 50.

That is, by incorporating the polyimides or the polyimide compounds, the protection film 53 can further enhance the adhesion performance between the packaging-material resin and the insulation layer 50.

Now, as shown in Fig. 12, the protection film 53, when assuming it also to be configured not reaching the upper face of field-plate electrode 82 and being layered on the upper face of second insulator 52 from the inner-end region 91a1 of the trench 91 to the intermediate region of trench 71, can provide the required effect.

[Fifth Embodiment]

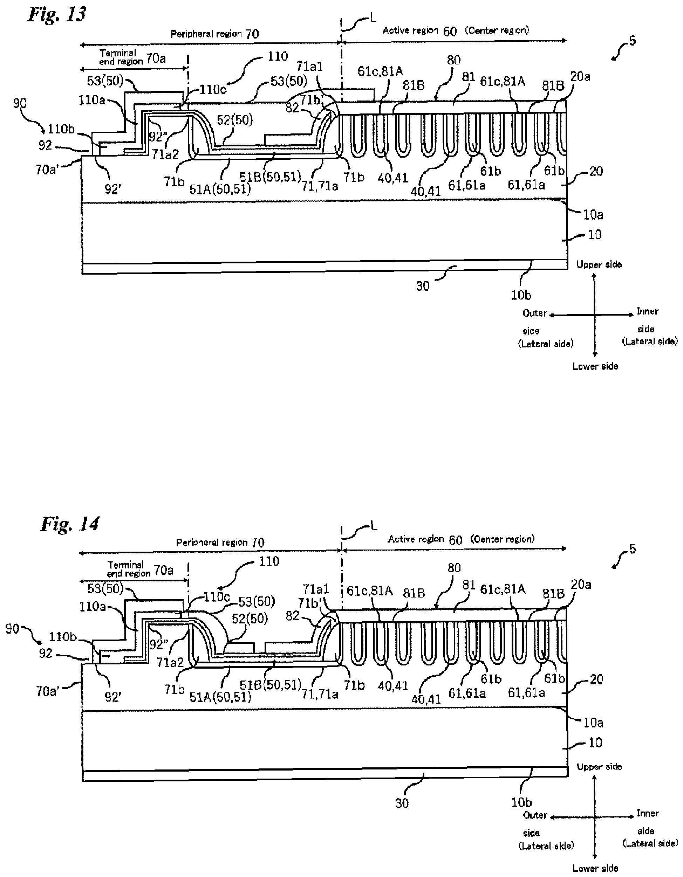

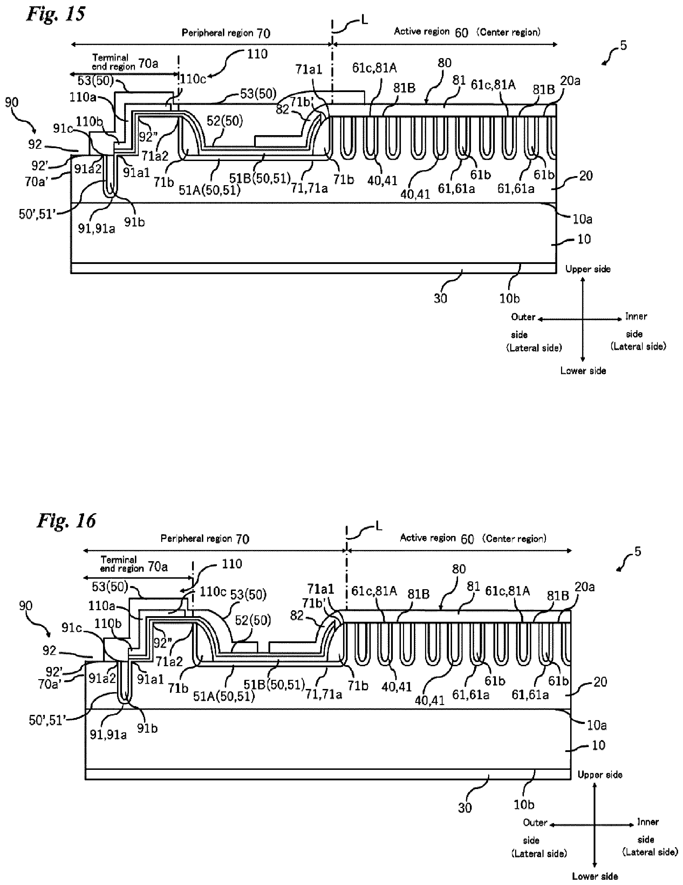

Next, a semiconductor device 5 according to the fifth embodiment of the present invention will be described in detail with reference to Fig. 13-Fig. 16. Fig. 13 is a front cross-sectional view illustrating the configuration for the same semiconductor device; Fig. 14 is a front cross-sectional view illustrating another configuration for the same semiconductor device; Fig. 15 is a front cross-sectional view illustrating further the other configuration for the same semiconductor device; and Fig. 16 is a front cross-sectional view illustrating also further the other configuration for the same semiconductor device. Now, in the following description and in Fig. 13-Fig. 16, with respect to configurations indicated by the same signs with the above-described embodiments and the similar configuration without descriptions, the descriptions would be sometimes omitted as they have the similar configurations with the above-described embodiment. In addition, in the descriptions hereunder, in the positioning which is viewed from the substrate 10 of semiconductor device 5, an upper side is defined to the side of epitaxial layer 20; a lower side is defined to the side of cathode electrode etc. 30; the center region 65 side of semiconductor device 5 is defined to an inner side; the terminal region 70a side (the side of terminal end 70a') is defined to an outer side; and each of the sides including other sides will be indicated clearly in drawings.

The semiconductor device 5 according to the fifth embodiment of the present invention presents the configuration in which the trench 92 of channel-current suppressing region 90 is formed as a stepwise shape.

That is, the semiconductor device 5, as shown in Fig. 13 and Fig. 14, is configured as to dispose the trench 92 formed to the channel-current suppressing region 90 by notching stepwise its terminal end region 70a side at the one-face 20a side of epitaxial layer 20 and as to make the stepwise-shaped trench 92 open the side at the outer terminal end 70a'. The trench 92 is disposed for going around at the side of one-face 20a side of epitaxial layer 20. To the inner face 92a of stepwise-shaped trench 92, the insulation layer 50, which is continuous from the trench 71, is disposed in a serpentine manner along the stepwise-shape, and the trench 92 is insulated to the epitaxial layer 20 in a predetermined manner. The insulation layer 50 includes the first insulator 51, the second insulator 52 and the protection film 53.

To the channel-current suppressing region 90 of semiconductor device 5, similarly to the third embodiment and the fourth embodiment as described above, the electrode 110 for controlling the channel current, i.e., an EQR (Equi-potential Ring: equipotential ring) electrode 110 is disposed. The EQR electrode 110 is disposed for going around the side of one-face 20a side of epitaxial layer 20. The EQR electrode 110 may be formed by electric-conductive materials. The EQR electrode 110 is disposed to cover the top surface of the second insulator 52 in the insulation layer 50. The EQR electrode 110 is disposed in a serpentine manner along the stepwise shape of trench 92.

The EQR electrode 110 has a first-electrode part 110a, a second-electrode part 110b, and a third-electrode part 110c. The first-electrode part 110a, second electrode part 110b, and third electrode part 110c are disposed continuously.

The first-electrode part 110a is disposed for extending vertically from the bottom 92' to the upper end 92" of stepwise-shaped trench 92. The first-electrode part 110a is disposed to the epitaxial layer 20 with intervening the first insulator 51 and the second insulator 52 in the insulation layer 50.

The second-electrode part 110b is disposed along the bottom 92' of stepwise-shaped trench 92. The second-electrode part 110b is the electrode part which practically extends from the lower end of first-electrode part 110a to the terminal end 70a' side (outside) as a strip-like shape.

The second-electrode part 110b contacts directly with the one-face 20a of epitaxial layer 20. That is, to the terminal end 70a' (outside) of bottom 92' in the stepwise trench 92, the first insulator 51 and the second insulator 52 are not disposed, and the second-electrode part 110b is the part, which is disposed directly to the epitaxial layer 20 without intervening the first insulator 51 and the second insulator 52. The EQR electrode 110 contacts electrically with the epitaxial layer 20 with intervening the second-electrode part 110b, which is disposed directly to the epitaxial layer 20.

The third-electrode part 110c practically extends from the upper end of first-electrode part 110a to the central region 65 side (inner side) along the one-face 20a of epitaxial layer 20. The third-electrode part 110c is disposed to the epitaxial layer 20 with intervening the first insulator 51 and the second insulator 52.

In the semiconductor device 5 of the fifth embodiment as configured above, the trench 92 disposed to the channel-current suppressing region 90 is configured by notching stepwise its terminal end region 70a side in the one-face 20a side of epitaxial layer 20 and by making the stepwise-shaped trench 92 open the side at the outer terminal end 70a' and can provide high resistance to further suppress the channel current flowing through the terminal end region 70a.

Here, the stepwise-shaped trench 92, as shown in Fig. 15 and Fig. 16, may further be formed with the trench 91 at its bottom 92' similarly to the third embodiment and the fourth embodiment. The second-electrode part 110b of EQR electrode 110 is disposed so as to cover the opening 91c of trench 91 and is configured to contact directly with the electric-conductive material 91b filled in the trench 91 without intervening the first insulator 51 and the second insulator 52 (to the inner face 91a of trench 91, the insulation layer 50' consisted only of the first insulator 51' is disposed.).

As described above, by further disposing the trench 91 at the bottom 92' of the stepwise-shaped trench 92, the channel current flowing through the terminal end region 70a' can be further suppressed synergistically together with the stepwise shape and the trench 91 at the bottom 92'.

Now, not shown in the drawings, when the trench 92 is formed as the stepwise shape, the EQR electrode 110 may be disposed above the upper face of insulation layer 50 via. the electric-conductive material 71b.

[Other Modifications, Applications]

The present invention should not be limited to the above-described embodiments, and of course, various modified implementations and applied implementations will be possible within the scope of claims.

For example, in the above-described embodiments, although the EQR electrode 110 has been described as one that has the second-electrode part 110b disposed directly to the epitaxial layer 20 without intervening the first insulator 51, the second insulator 52 in the insulation layer 50 and the insulation layer 50', the configuration with intervening the first insulator 51 and the second insulator 52 in the insulation layer 50 and the insulation layer 50' between the second-electrode part 110b and the epitaxial layer 20 to insulate the second-electrode part 110b to the epitaxial player 20, can provide the required effects.

However, the configuration, in that the EQR electrode 110 has the second-electrode part 110b disposed directly to the epitaxial layer 20 without intervening the first insulator 51 and the second insulator 52 in the insulation layer 50 and the insulation layer 50', becomes further preferable embodiment, because the EQR electrode 110 can be connected electrically with the epitaxial layer 20 to enhance the suppression effect for the channel current. Now, in the above-described embodiments, the configuration, in that the first insulator 51 and the second insulator 52 in the insulation layer 50 and the insulation layer 50' is practically extended in a short length from the outside end region 71 a1 of opening 91c in the trench 91 to the terminal end 70a' and the first insulator 51 and the second insulator 52 in the insulation layer 50, and the insulation layer 50'makes partially present between the second-electrode part 110b and the epitaxial layer 20, can provide the required effects.

Furthermore, in the embodiments described above, it is assumed that the first-electrode part 110a of EQR electrode 110 is connected directly with the electric-conductive material 91b filled in the trench 91 without intervening the first insulator 51 and the second insulator 52 in the insulation layer 50 and the insulation layer 50'; however, the configuration, in that the second-electrode part 110b of EQR electrode 110 is insulated to the electric-conductive material 91b with intervening the first insulator 51 and the second insulator 52 in the insulation layer 50 and the insulation layer 50', can provide the required effects.

However, the configuration, in that the second-electrode part 110b of EQR electrode 110 is connected directly with the electric-conductive material 91b filled in the trench 91 without intervening the first insulator 51 and the second insulator 52 in the insulation layer 50 and the insulation layer 50', becomes a further preferred embodiment, because the channel current can be surely led to the trench 91.

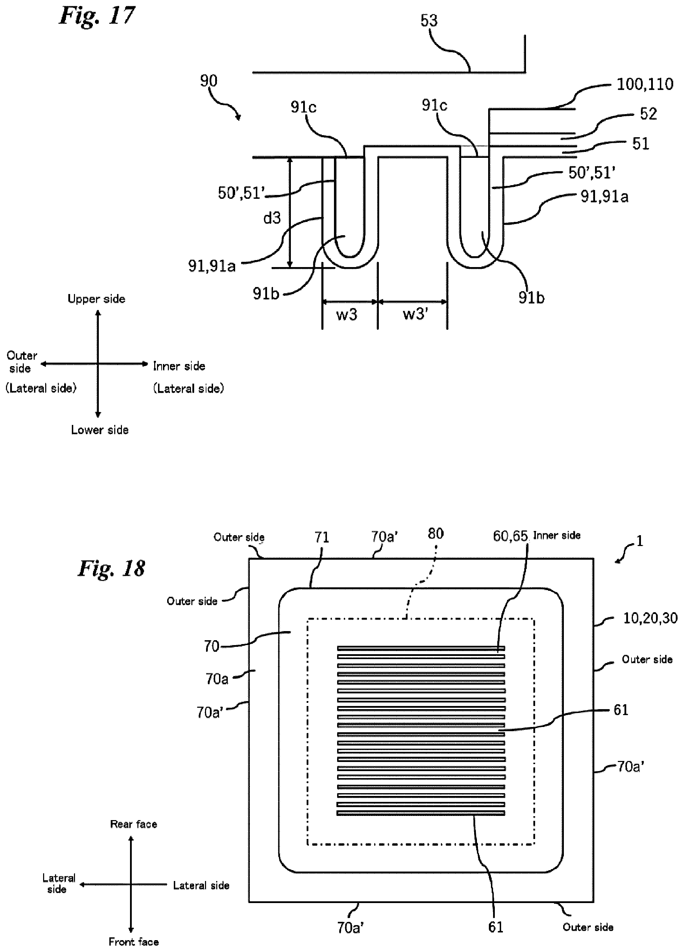

Also furthermore, as shown in Fig. 17, the plurality of trenches 91 disposed to the channel-current suppressing region 90 may be formed along the direction that the channel current flows. In this case, the configuration, in that the mesa width of trench 91 (spacing between adjacent trenches 91) w3' is set to be a width size wider than the trench width w3, may become further preferred embodiment. That is, by setting the mesa width w3' of trench 91 to be wider than the trench width w3, the channel-current flow can be surely intercepted by the trench 91 in the channel-current suppressing region 90. The ratio A of mesa width w3' to the trench width w3 of trench 91 shown in Equation 1 may range, for example, 1.0-3.0. Here, even though the mesa width w3' may be narrower than the trench width w3, required effects may be provided.

$$[\text{Eq. 1}] \qquad\qquad A = w3'/w3$$

Besides, in the above embodiments, although it is assumed that the cross-sectional shape of trench 91 is set to a U-shape viewed from the front, the cross-sectional shapes such as a triangle shape and other shapes etc., which are different from the trench 61 of active region 60, become preferable embodiments, since required effects to the suppression of channel current may be provided.

Here, the configuration, in that the channel-current suppression region 90 is disposed only to the trench 91 while omitting the EQR electrode 110, may provide the required effects for the suppression of channel current. However, the configuration, in that the EQR electrode 110 is disposed to the channel-current suppression region 90, may further suppress the channel current flowing in the terminal end region 70a by the synergistic effects together with the effects from the trench 91.

Furthermore, in the above-described embodiments, although it is assumed that the element disposed to the active region 60 is the diode 80, more particularly the schottky-barrier diode 80, the required effects to the suppression of channel current may be obtained in other diodes such as a switching diode or a fast-recovery diode etc. or other electronic elements other than diodes.

However, the schottky barrier diode 80 has the particular importance of the present invention to which the inverse current causes significant performance degradation.

Furthermore, in the above-described embodiments, although the first insulator 51 may include the silicon oxides (for example, silicon dioxide ($SiO_2$)); the second insulator 52 may include any of silicon nitrides (for example, silicon nitride (SiN, $Si_3N_4$)), hafnium compounds (for example, hafnium dioxide ($HfO_2$)), titanium oxides (for example, ($TiO_2$)), and aluminum oxides ($Al_2O_3$); and the protection film 53 is adopted from the polyimides or the polyimide compounds, the required effect may be provided by configuring other materials having the insulation performance and the dielectric performance.

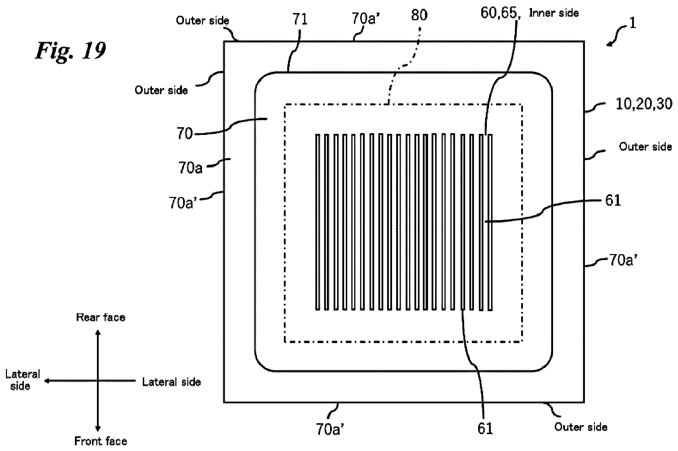

Yet moreover, in the above-described embodiment, the trench 61 is assumed to be the recessed shape going around the one-face 20a side of epitaxial layer 20 and as shown in Fig. 18, may alternatively be disposed linearly in one lateral direction, or as shown in Fig. 19, may be disposed linearly in one vertical direction, not being limited to the going-around configuration.

Yet moreover, in the above-described embodiment, the upper-face side of insulation layer 50 is sealed by the packaging-material resin; however, as in the case sold in a wafer state or in a chip state, the configuration of which sealing is not applied by the packaging resin material to expose the insulation layer 50 may be possible.

[Description of Signs]

A: ratio
L: boundary
d1, d2, d3: depth size
w1, w2, w3: width size
w3': mesa width
1, 2, 3, 4, 5: semiconductor device
10: substrate
10a: one-face
10b: other face
20: epitaxial layer
20a: one-face
30: cathode electrode etc.
40: insulation layer
41: insulator
50: insulation layer
50': insulation layer
51: first insulator
51A: lower side insulator
51B: upper side insulator
51': insulator
52: second insulator
53: protection film
60: active layer
61: trench
61a: inner face
61b: electric-conductive material
61c: opening
65: center region
70: peripheral region
70a: terminal end region
70a': terminal end
71: trench
71a: inner face
71a1, 71a2: end region
71b: electric-conductive material
71b': exposed region
80: diode (schottky-barrier diode)
81: schottky electrode
81A: first-electrode part
81B: second-electrode part
82: field-plate electrode

90: channel-current suppression region
91: trench
91a: inner face
91a1: inner-end region
91a2: outer-end region
91b: electric-conductive material
91c: opening
92: trench
92': bottom
92": upper end
100: electrode (EQR electrode)
100a: first-electrode part
100b: second-electrode part
100c: third-electrode part
110: electrode (EQR electrode)
110a: first-electrode part
110b: second-electrode part
110c: third-electrode part

**Claims**

1. A semiconductor device having a substrate, an epitaxial layer formed to the substrate, and an insulation layer disposed at a one-face side of the epitaxial layer,

   wherein an active layer is disposed to a one-face side of the epitaxial layer with intervening the insulating layer, and a trench is disposed to a peripheral region formed at an outside region of the active layer, and
   wherein an insulation layer disposed to the peripheral region is configured by layering a first insulator and a second insulator having different relative dielectric constants.

2. The semiconductor device of claim 1, wherein a relative dielectric constant of the second insulator is set to be 5-200.

3. The semiconductor device of claim 1, wherein a relative dielectric constant of the second insulator is set to be 5-30.

4. The semiconductor device of claim 1, wherein a relative dielectric constant of the second insulator is set to be 5-10.

5. The semiconductor device of claim 1, wherein the insulation layer further includes a protection film, and the protection film is disposed by layering to the first insulator and the second insulator.

6. The semiconductor device of claim 1, wherein the first insulator includes oxides.

7. The semiconductor device of claim 6, wherein the oxide includes silicon oxides.

8. The semiconductor device of claim 1, wherein the second insulator includes silicone compounds or oxides.

9. The semiconductor device of claim 8, wherein the silicon compound includes silicon nitrides.

10. The semiconductor device of claim 8, wherein the oxides at least include any of hafnium oxides, titanium oxides and aluminum oxides.

11. The semiconductor device of claim 5, wherein the protection film includes polyimides or polyimide compounds.

12. The semiconductor device of claim 1, wherein a channel-current suppression region is disposed to a terminal end region of the peripheral region, and a trench is further disposed to the channel-current suppressing region, wherein the trench suppresses a channel current flowing from the active region to the terminal end region side.

13. The semiconductor device of claim 12, wherein the channel-current suppressing region is further disposed with an electrode for suppressing the channel-electrode.

**14.** The semiconductor device of claim 13, wherein the electrode for suppressing the channel current is an EQR electrode.

**15.** The semiconductor device of claim 12, wherein the trench disposed to the channel-current suppressing region is disposed by notching stepwise a terminal end region side in a one-face side of the epitaxial layer and a trench having the stepwise shape is configured to open an outer lateral side.

**16.** The semiconductor device of claim 15, wherein the trench having the stepwise shape is further disposed with a trench at a bottom.

*Fig. 1*

Outer side    71    70a'    80    60,65, Inner side    1

Outer side

Outer side

10,20,30

70

70a    Outer side

70a'    61

61

70a'

Rear face

A    A    70a'

Lateral
side    Lateral side

Front face    70a'    61    Outer side

*Fig. 2*

L

Peripheral region 70    Active region 60    (Center region)    1

Terminal
end region 70a    71a1    61c,81A    81B    80    81    61c,81A    81B    20a
71b'    82

52(50)    71b
70a'    71a2    40,41    61b    61b    20
71b    51B(50,51)    71,71a    40,41    61,61a    61,61a    10a
51A(50,51)

10

30

Upper side    10b

Outer    Inner
side    side
(Lateral side)    (Lateral side)

Lower side

*Fig. 3*

Upper side

Outer side (Lateral side) ← → Inner side (Lateral side)

Lower side

*Fig. 4*

Upper side

Outer side (Lateral side) ← → Inner side (Lateral side)

Lower side

*Fig. 5*

Peripheral region 70     L     Active region 60 (Center region)

Terminal end region 70a

53(50)

52(50)

71a1
71b'
82

71a2

70a'

71b
51A(50,51)   51B(50,51)   71,71a   71b   40,41   40,41   61,61a   61b   61,61a   61b

61c,81A   81B   80   81   61c,81A   81B   20a

20

10a

10

30

10b

Upper side

Outer side (Lateral side) ← → Inner side (Lateral side)

Lower side

*Fig. 6*

Peripheral region 70     L     Active region 60 (Center region)

Terminal end region 70a

53(50)

52(50)

71a1
71b'
82

71a2

70a'

71b
51A(50,51)   51B(50,51)   71,71a   71b   40,41   40,41   61,61a   61b   61,61a   61b

61c,81A   81B   80   81   61c,81A   81B   20a

20

10a

10

30

10b

Upper side

Outer side (Lateral side) ← → Inner side (Lateral side)

Lower side

16

*Fig. 7*

Peripheral region 70    L    Active region 60 (Center region)

Terminal end region 70a   53(50)   71a1   61c,81A   80   81   61c,81A   81B   20a

71b'   81B   82

70a'

71a2   52(50)

71b   51B(50,51)   71,71a   71b   40,41   61b   61b   20

51A(50,51)   40,41   61,61a   61,61a   10a

10

30

10b

Upper side

Outer side (Lateral side)    Inner side (Lateral side)

Lower side

*Fig. 8*

Outer side   71   70a'   80   60,65, Inner side   3

Outer side    100

10,20,30

91   70    Outer side

70a

70a'    61

70a'

Rear face

A

Lateral side   Lateral side   A   61

Front face    70a'   61    Outer side

**Fig. 9**

Peripheral region 70     L     Active region 60  (Center region)     3

Terminal end region 70a

90   100   100a   100c   71a2   61c,81A   81B   80   81   61c,81A   81B   20a

91c   71b'   82   52(50)   71a1

100b   91a2   91a1

70a'

50',51'   91b   71b   51A(50,51)   51B(50,51)   71,71a   71b   40,41   40,41   61b   61b   20

91,91a   61,61a   61,61a

10a   10   30   10b

Upper side

Outer side (Lateral side) — Inner side (Lateral side)

Lower side

**Fig. 10**

90   100   91c   100a   100c   100b   91a2   91a1   d3   50',51'   91,91a   91b   w3

Upper side

Outer side (Lateral side) — Inner side (Lateral side)

Lower side

## Fig. 11

## Fig. 12

**Fig. 13**

**Fig. 14**

*Fig. 15*

*Fig. 16*

*Fig. 17*

Upper side

Outer side (Lateral side) ← → Inner side (Lateral side)

Lower side

*Fig. 18*

Rear face

Lateral side ← → Lateral side

Front face

*Fig. 19*

## INTERNATIONAL SEARCH REPORT

| International application No. |
| --- |
| **PCT/JP2023/001274** |

| A. | CLASSIFICATION OF SUBJECT MATTER |
| --- | --- |

*H01L 29/06*(2006.01)i; *H01L 29/78*(2006.01)i; *H01L 29/872*(2006.01)i
FI: H01L29/06 301M; H01L29/06 301G; H01L29/06 301V; H01L29/78 652N; H01L29/78 652P; H01L29/86 301E; H01L29/86 301F

According to International Patent Classification (IPC) or to both national classification and IPC

| B. | FIELDS SEARCHED |
| --- | --- |

Minimum documentation searched (classification system followed by classification symbols)

H01L29/06; H01L29/78; H01L29/872

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | JP 2021-120990 A (KABUSHIKI KAISHA TOYOTA CHUO KENKYUSHO) 19 August 2021 (2021-08-19) paragraphs [0014]-[0028], fig. 1 | 1-4, 6-8, 10 |
| Y | | 5, 9, 11 |
| A | | 12-16 |
| Y | JP 2015-126027 A (TOYOTA JIDOSHA KABUSHIKI KAISHA) 06 July 2015 (2015-07-06) paragraphs [0020]-[0026], fig. 1-3 | 1, 5-8, 11 |
| A | | 2-4, 9, 10, 12-16 |
| Y | JP 2013-69783 A (KABUSHIKI KAISHA TOSHIBA) 18 April 2013 (2013-04-18) paragraphs [0013]-[0016], fig. 1-3 | 1, 5-9, 11 |
| Y | JP 2021-125478 A (DENSO CORPORATION) 30 August 2021 (2021-08-30) paragraph [0009], fig. 1 | 5, 11 |

☐ Further documents are listed in the continuation of Box C.      ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **30 March 2023** | **11 April 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2023/001274**

| Patent document cited in search report | | | Publication date (day/month/year) | Patent family member(s) | Publication date (day/month/year) |
|---|---|---|---|---|---|
| JP | 2021-120990 | A | 19 August 2021 | (Family: none) | |
| JP | 2015-126027 | A | 06 July 2015 | US 2016/0315157 A1 paragraphs [0029]-[0036], fig. 1-3 WO 2015/098244 A1 DE 112014005992 T5 TW 201526237 A CN 105874576 A | |
| JP | 2013-69783 | A | 18 April 2013 | (Family: none) | |
| JP | 2021-125478 | A | 30 August 2021 | (Family: none) | |

Form PCT/ISA/210 (patent family annex) (January 2015)

**EP 4 621 851 A1**

**Patent documents cited in the description**

- JP 2020505769 A